Europäisches Patentamt

**European Patent Office**

**Office européen des brevets**

(19)

(11) Numéro de publication : **0 080 030 B1**

(12)

# FASCICULE DE BREVET EUROPÉEN

(45) Date de publication du fascicule du brevet :
**26.03.86**

(21) Numéro de dépôt : **82107667.6**

(22) Date de dépôt : **15.04.80**

(60) Numéro de publication de la demande initiale en application de l'article 76 CBE : **0019499**

(51) Int. Cl.⁴ : **H 05 K   7/02**, H 04 N   5/655, **H 05 K   3/36**

(54) **Récepteur de télévision à châssis support de circuits imprimés épousant la forme du tube cathodique.**

(30) Priorité : **18.05.79 FR 7912710**

(43) Date de publication de la demande :
**01.06.83 Bulletin 83/22**

(45) Mention de la délivrance du brevet :
**26.03.86 Bulletin 86/13**

(84) Etats contractants désignés :
**BE DE GB IT NL**

(56) Documents cités :
**FR-A- 1 457 546**
**FR-A- 2 346 925**
**US-A- 3 780 431**
**US-A- 3 789 140**
**US-A- 3 914 547**
**US-A- 4 002 398**

(73) Titulaire : **SOCIETE D'ELECTRONIQUE DE LA REGION PAYS de LOIRE - SEREL**
**74, rue du Surmelin**
**F-75020 Paris (FR)**

(72) Inventeur : **Bleynie, Jean-Marie**
**THOMSON-CSF SCPI 173, bld Haussmann**
**F-75379 Paris Cedex 08 (FR)**
Inventeur : **Narbonne, Claude**
**THOMSON-CSF SCPI 173, bld Haussmann**
**F-75379 Paris Cedex 08 (FR)**
Inventeur : **Pataillot, Georges**
**THOMSON-CSF SCPI 173, bld Haussmann**
**F-75379 Paris Cedex 08 (FR)**

(74) Mandataire : **Grynwald, Albert et al**
**THOMSON-CSF SCPI 19, avenue de Messine**
**F-75008 Paris (FR)**

## Description

La présente invention concerne un récepteur de télévision comprenant un châssis portant des circuits imprimés de forme telle qu'il épouse approximativement la forme du tube cathodique avec une partie centrale traversée par le col du tube et des parties latérales suivant sensiblement la direction des parois latérales coniques du tube.

Dans un récepteur connu de ce genre (brevet français 1 457 546) le châssis est fixé à l'ébénisterie du tube. Ce récepteur est mal adapté à la fabrication en grande série et rend les réparations malaisées.

L'invention remédie à ces inconvénients. Elle est caractérisée en ce que les extrémités des parties latérales du châssis sont fixées au tube à la périphérie de l'écran. Ainsi la fabrication en série et les réparations sont facilitées.

Dans une réalisation, les extrémités des parties latérales du châssis comportent des pattes ajustées au profil méridien du tube.

D'autres avantages et caractéristiques de l'invention apparaîtront dans la description qui suit, donnée à l'aide des figures qui représentent :

la figure 1,  un exemple de châssis terminé et monté sur un tube cathodique de récepteur de télévision.

la figure 2,  les positions relatives des circuits imprimés et de l'ébauche du châssis avant pliage et montage sur le tube-image du récepteur de télévision.

les figures 3a et 3b, deux exemples de stockage des ébauches de châssis comportant le circuit imprimé câblé.

Dans la description de l'exemple non limitatif qui suit le châssis est supposé métallique et obtenu par découpage dans une plaque de métal.

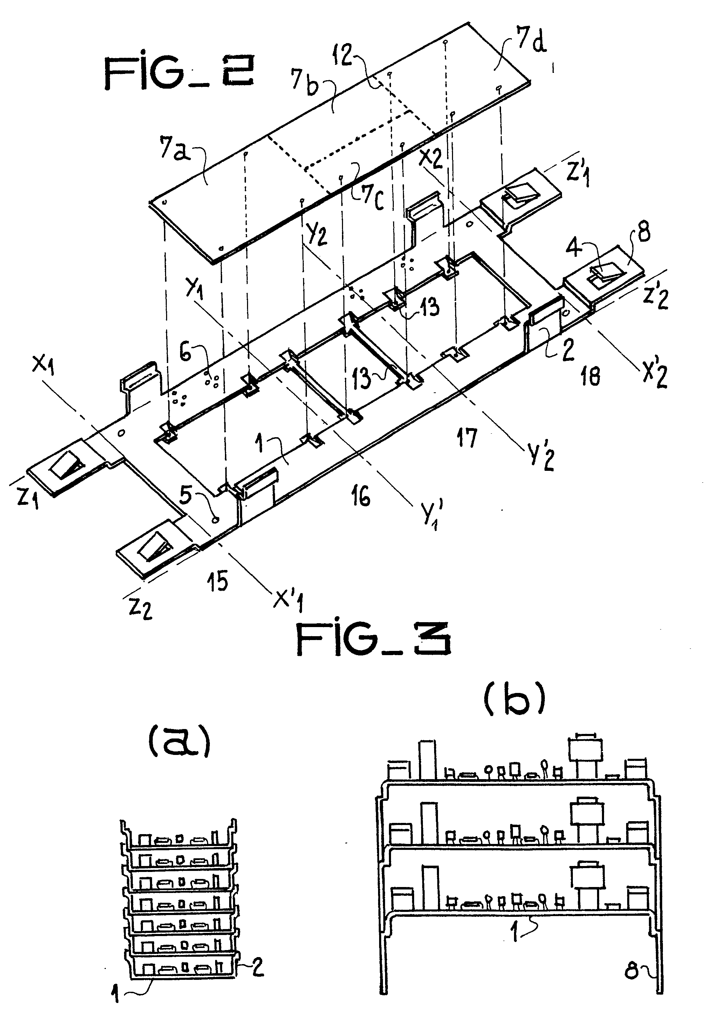

La figure 2 montre un châssis métallique et le circuit imprimé associé en cours de réalisation. Le châssis métallique 1 découpé comporte un ensemble de pattes 2 et 8 se trouvant sur les côtés et sur les extrémités du châssis métallique 1 proprement dit. Ces pattes 2 et 8, ou du moins certaines d'entre elles, sont après découpage du châssis métallique 1 dans la plaque de métal plane, pliées suivant un certain profil autorisant un empilage des châssis métalliques 1 et aménageant entre deux châssis métalliques 1 successifs un espace vide évitant que les composants sur le circuit imprimé soient détériorés par le châssis voisin.

Les pattes 8 correspondant aux extrémités du châssis métallique 1 possèdent des moyens 4 permettant une fixation ultérieure du châssis métallique 1 sur le tube cathodique d'un récepteur de télévision.

Ces moyens de fixation 4 peuvent être par exemple des pattes secondaires ou des fentes, pratiquées dans les pattes principales 8 de façon à permettre un cerclage efficace autour du tube cathodique.

Le châssis métallique 1 comprend des moyens 13, réalisés par une opération de découpage, de fixation du circuit imprimé 7 en plusieurs endroits du châssis métallique 1, ces endroits étant déterminés par la nécessité de conserver après rupture du circuit imprimé 7 certains fragments de ce circuit imprimé 7 fixés rigidement sur le châssis métallique 1.

Des trous 5 sont également pratiqués dans le châssis métallique 1, de façon à permettre, au cours de la fabrication, un guidage des châssis métalliques 1 par empilage sur des tiges et/ou leur entraînement sur les chaînes de montage, par exemple entre deux étapes de la fabrication.

Enfin des logements 6 de forme adaptée sont ménagés dans le châssis métallique 1 pour les composants spéciaux comme par exemple les transistors de puissance permettant ainsi l'utilisation de ce châssis comme radiateur thermique, et une fixation plus rigide.

L'unique circuit imprimé 7, qui est gravé et perforé en fonction des circuits qu'il est amené à supporter, comporte des perforations supplémentaires à des distances régulières les unes des autres et selon des lignes prédéterminées 12, pouvant par exemple être des segments de droite. Celles-ci forment des lignes de moindre résistance telles que, au cours d'un pliage de ce circuit imprimé, celui-ci ne puisse se casser que suivant ces lignes 12 prédéterminées. On peut également arriver à ce résultat en remplaçant la perforation en pointillé par une fente de profondeur convenable pratiquée sur l'une ou les deux faces du circuit imprimé 7, chaque fente ou couple de fentes, qui sont alors symétriques par rapport au plan de symétrie du circuit imprimé 7, déterminant une ligne de moindre résistance 12.

Le circuit imprimé 7 est fixé rigidement sur le châssis métallique 1 ; il comporte les divers composants électroniques, les prises de branchement devant permettre d'assurer, en fonctionnement, par exemple l'alimentation en énergie électrique, ou le raccordement d'accessoires divers. Il comprend également les connexions souples qui relient électriquement les fragments (7a, 7b, 7c, 7d) du circuit imprimé 7 après rupture au niveau des lignes 12 de moindre résistance ; ces connexions souples qui peuvent être constituées de fils électriques ou de circuits imprimés souples assurent également un lien mécanique entre les fragments libres et ceux fixés rigidement sur le châssis métallique 1.

Le circuit imprimé 7 peut être soudé, en même temps que sont soudés les composants par la technique de soudure à la vague, sur le châssis métallique 1 à l'aide des moyens de fixation 13 qui peuvent être alors simplement constitués par des pattes métalliques.

Les figures 3a et 3b montrent deux exemples de stockage du châssis métallique avant fixation au tube. La figure 3a montre un stockage par empilage en se servant des pattes latérales 2 du châssis métallique 1, ces pattes 2 étant repliées vers la face du circuit imprimé 7 supportant les composants électroniques, d'un angle de 90° ; la figure 3b montre un stockage par empilage en se servant des pattes 8 se trouvant aux extrémités du châssis métallique 1, ces pattes 8 étant repliées d'un angle de 90° vers la face du circuit imprimé 7 comportant les soudures.

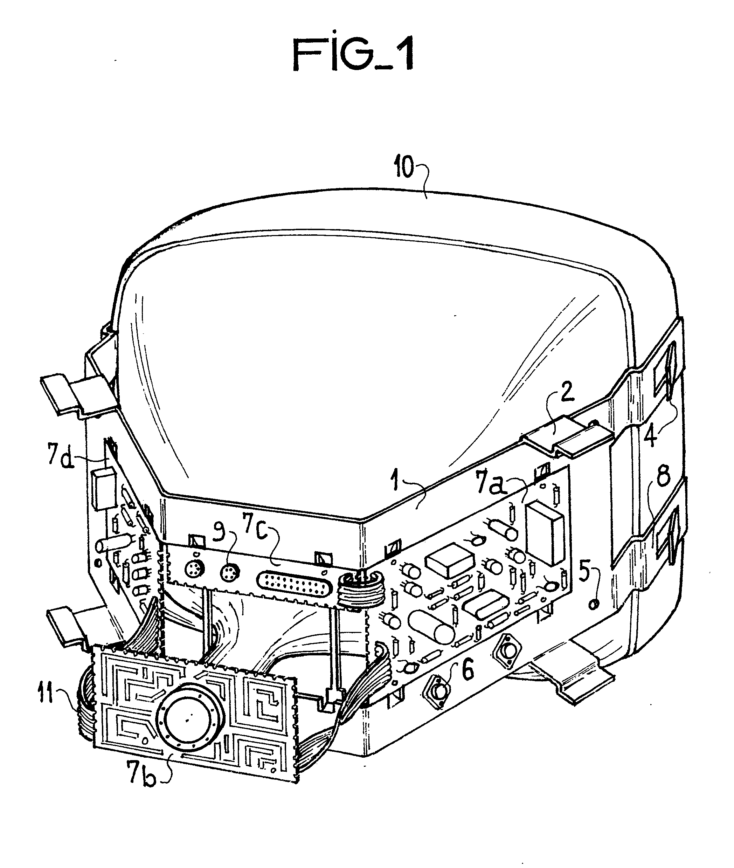

Le châssis métallique 1 et le circuit imprimé 7 représentés sur la figure 1 résultent du pliage par exemple selon quatre axes parallèles $x_1x_1'$, $x_2x_2'$, $Y_1Y_1'$, et $Y_2Y_2'$ de façon à obtenir une forme du châssis métallique 1 la plus proche possible du contour extérieur de la pièce sur laquelle il est monté, par exemple un tube cathodique d'un récepteur de télévision. Cette forme de pliage permet ainsi d'obtenir un encombrement supplémentaire minimum par rapport à l'encombrement initial par exemple du tube cathodique 10. Le circuit imprimé 7 est formé par exemple de morceaux (7a, 7b, 7c, 7d) délimités par les lignes 12 de moindre résistance, ces morceaux étant séparés au cours du pliage du châssis. Les connexions souples 11 reliant ces circuits permettent de conserver les liaisons électriques, ainsi que des liens mécaniques ; en effet, dans l'exemple montré ici sur la figure 1, le fragment du circuit imprimé 7b fixé directement sur le tube cathodique 10, est libre du châssis métallique 1 et des autres fragments du circuit imprimé 7, et n'est donc retenu que par les connexions souples 11 permettant également un raccordement plus aisé au tube cathodique 10. Cette disposition permet en outre d'éviter les liaisons électriques entre les différents châssis de l'art antérieur qui, le plus souvent, étaient fixées sur l'ébénisterie du récepteur de télévision d'où une difficulté de câblage et éventuellement de dépannage, cette opération de dépannage devant se faire le tube cathodique 10 monté dans l'ébénisterie. Les pattes latérales 2 n'ont leurs positions modifiées que si elles gênent d'autres pièces extérieures à celles considérées dans cette description comme par exemple le capot arrière du récepteur de télévision ; par contre, les pattes 8 correspondant aux extrémités du châssis métallique 1, sont orientées de façon à permettre une fixation aisée au tube cathodique 10 sur lequel le châssis métallique 1 est monté. On peut alors, dans un mode préférentiel, mais non limitatif, mettre en forme les pattes extérieures 8 de façon à ce qu'elles soient ajustées au profil méridien de l'écran du tube cathodique 10, permettant ainsi un cerclage en utilisant les pattes secondaires 4 pour maintenir le cerclage en place.

Le châssis est raccordé aux organes de commande par exemple du panneau avant du récepteur de télévision, à l'aide des prises de branchement 9 prévues sur certains fragments du circuit imprimé 7.

Un avantage de l'invention est que l'ensemble des circuits électroniques n'est inséré dans l'ébénisterie qu'à l'étape ultime.

Un autre avantage est de pouvoir adapter ces châssis à un format quelconque de tube cathodique, seul changeant alors le dispositif de fixation que l'on doit prévoir soit sur l'ébénisterie soit sur le tube cathodique par un dispositif non décrit ici qui doit être adapté aux pattes extérieures 8 ou latérales 2.

Le châssis support 1 peut être en une matière quelconque autre que le métal. Dans le cas où ce matériau est par exemple du type matière plastique, polyéthylène ou autre, des radiateurs thermiques supplémentaires sont fixés sur ce châssis 1.

Enfin ce châssis support 1 peut être obtenu soit par découpage d'une plaque d'un matériau déterminé, soit par coulage dans un moule ayant la forme désirée.

**Revendications**

1. Récepteur de télévision comprenant un châssis (1) portant des circuits imprimés, de forme telle qu'il épouse approximativement la forme du tube cathodique (10) avec une partie centrale traversée par le col du tube et des parties latérales suivant sensiblement la direction des parois latérales coniques du tube, caractérisé en ce que les extrémités des parties latérales du châssis (1) sont fixées au tube (10) à la périphérie de l'écran.

2. Récepteur selon la revendication 1, caractérisé en ce que les extrémités des parties latérales du châssis (1) comportent des pattes (8) ajustées au profil méridien du tube (10).

3. Récepteur selon la revendication 2, caractérisé en ce que les pattes (8) aux extrémités du châssis (1) présentent des pattes secondaires (4) ou des fentes permettant un cerclage autour du tube cathodique.

4. Récepteur selon l'une quelconque des revendications précédentes, caractérisé en ce que le châssis présente des pattes (2) formant entretoises séparant ce châssis d'un châssis voisin lors d'un stockage.

5. Récepteur selon l'une quelconque des revendications précédentes, caractérisé en ce que le châssis (1) étant métallique il présente au moins un logement (6) pour un composant comme un transistor de puissance, ce châssis constituant alors un radiateur.

6. Récepteur selon l'une quelconque des revendications précédentes, caractérisé en ce que le châssis (1) présente des trous (5) pour son guidage ou son entraînement lors de sa fabrication.

7. Récepteur selon l'une quelconque des revendications précédentes, caractérisé en ce que les circuits sont sur des plaquettes ($7_a$, $7_b$, $7_c$, $7_d$) de circuits imprimés portées par le châssis (1).

8. Récepteur selon la revendication 7, caractérisé en ce que les plaquettes ($7_a$, $7_b$, $7_c$, $7_d$) de circuits imprimés sont reliées entre elles par des liaisons électriques souples (11) jouant également le rôle de liaisons mécaniques entre ces plaquettes.

9. Récepteur selon la revendication 7 ou 8, caractérisé en ce qu'un fragment de plaquette de circuit imprimé (7$_b$) est fixé directement sur le tube cathodique (10), notamment le col, et est libre par rapport au châssis (1).

10. Récepteur selon l'une quelconque des revendications précédentes, caractérisé en ce que le châssis est métallique.

11. Récepteur selon l'une quelconque des revendications 1 à 9, caractérisé en ce que le châssis est en une matière plastique.

## Claims

1. Television receiver comprising a chassis (1) carrying printed circuits and shaped in a manner to substantially follow the shape of the cathode ray tube (10), having a central portion traversed by the neck of the tube and lateral portions substantially following the direction of the lateral conical walls of the tube, characterized in that the ends of the lateral portions of the chassis (1) are fixed to the tube (10) at the periphery of the screen.

2. Receiver according to claim 1, characterized in that the ends of the lateral portions of the chassis (1) comprise lugs (8) adjusted to the meridian profile of the tube (10).

3. Receiver according to claim 2, characterized in that the lugs (8) at the ends of the chassis (1) have secondary lugs (4) or slots permitting the cathode ray tube to be encircled.

4. Receiver according to any of the preceding claims, characterized in that the chassis has lugs (2) forming struts separating this chassis from a neighbouring chassis during storage.

5. Receiver according to any of the preceding claims, characterized in that the chassis (1) is metallic and has at least one accommodation (6) for a component such as a power transistor, this chassis then forming a radiator.

6. Receiver according to any of the preceding claims, characterized in that the chassis (1) has holes (5) for the guiding or entraining thereof during its manufacture.

7. Receiver according to any of the preceding claims, characterized in that the circuits are on printed circuit boards (7$_a$, 7$_b$, 7$_c$, 7$_d$) carried by the chassis (1).

8. Receiver according to claim 7, characterized in that the printed circuit boards (7$_a$, 7$_b$, 7$_c$, 7$_d$) are interconnected by flexible electric connections (11) which aditionally function as mechanic connections between these boards.

9. Receiver according to claim 7 or 8, characterized in that a fraction of printed circuit board (7$_b$) is directly secured to the cathode ray tube (10), in particular to its neck, and is free with respect to the chassis (1).

10. Receiver according to any of the preceding claims, characterized in that the chassis is metallic.

11. Receiver according to any of claims 1 to 9, characterized in that the chassis is of a plastic material.

## Patentansprüche

1. Fernsehempfänger mit einem Chassis (1), welches gedruckte Schaltungen trägt, von solcher Form, daß es annähernd an die Form der Kathodenstrahlröhre (10) angeschmiegt ist, mit einem zentralen Teil, welcher von dem Röhrenhals durchquert wird, und seitlichen Teilen im wesentlichen längs der Richtung der konischen Seitenwände der Röhre, dadurch gekennzeichnet, daß die Enden der seitlichen Teile des Chassis (1) an der Röhre (10) am Umfang des Bildschirms befestigt sind.

2. Empfänger nach Anspruch 1, dadurch gekennzeichnet, daß die Enden der seitlichen Teile des Chassis (1) Laschen (8) aufweisen, die an das Meridianprofil der Röhre (10) angepaßt sind.

3. Empfänger nach Anspruch 2, dadurch gekennzeichnet, daß die Laschen (8) an den Enden des Chassis (1) sekundäre Laschen (4) oder Schlitze aufweisen, die eine Umreifung um die Kathodenstrahlröhre herum gestatten.

4. Empfänger nach einem der vorstehenden Ansprüche, dadurch gekennzeichnet, daß das Chassis Laschen (2) aufweist, die Streben bilden, welche dieses Chassis von einem benachbarten Chassis während der Lagerung trennen.

5. Empfänger nach einem der vorstehenden Ansprüche, dadurch gekennzeichnet, daß das Chassis (1) aus Metall besteht und wenigstens eine Aufnahme (6) für ein Bauteil wie einen Leistungstransistor umfaßt, wobei dieses Chassis dann einen Kühlkörper bildet.

6. Empfänger nach einem der vorstehenden Ansprüche, dadurch gekennzeichnet, daß das Chassis (1) Löcher (5) für seine Führung oder seine Mitbewegung während seiner Herstellung aufweist.

7. Empfänger nach einem der vorstehenden Ansprüche, dadurch gekennzeichnet, daß die Schaltungen auf Karten (7$_a$, 7$_b$, 7$_c$, 7$_d$) gedruckter Schaltkreise angeordnet sind und vom Chassis (1) getragen werden.

8. Empfänger nach Anspruch 7, dadurch gekennzeichnet, daß die gedruckten Schaltungskarten (7$_a$, 7$_b$, 7$_c$, 7$_d$) untereinander durch flexible elektrische Verbindungen (11) verbunden sind, welche auch die Funktion von mechanischen Verbindungen zwischen diesen Karten erfüllen.

9. Empfänger nach Anspruch 7 oder 8, dadurch gekennzeichnet, daß ein Bruchteil einer gedruckten Schaltungskarte (7$_b$) direkt an der Kathodenstrahlröhre (10) befestigt ist, insbesondere am Hals, und bezüglich des Chassis (1) frei ist.

10. Empfänger nach einem der vorstehenden Ansprüche, dadurch gekennzeichnet, daß das Chassis aus Metall besteht.

11. Empfänger nach einem der Ansprüche 1 bis 9, dadurch gekennzeichnet, daß das Chassis aus einem Plastikmaterial besteht.

# FIG_1

FIG_2

FIG_3

(b)

(a)